# FASCICULE DE BREVET EUROPEEN

(11) **EP 3 952 624 B1**
(45) Date de publication et mention de la délivrance du brevet: **10.07.2024**
(21) Numéro de dépôt: 21189169.2
(22) Date de dépôt: 02.08.2021
(51) Int. Cl.: H05K 7/14

(54) **ENSEMBLE ÉLECTRONIQUE MODULAIRE ET SYSTÈME VIDÉO NOMADE COMPORTANT UN TEL ENSEMBLE**
MODULARE ELEKTRONISCHE ANORDNUNG UND MOBILES VIDEOSYSTEM MIT EINER SOLCHEN ANORDNUNG
MODULAR ELECTRONIC ASSEMBLY AND MOBILE VIDEO SYSTEM COMPRISING SUCH AN ASSEMBLY

(30) Priorité: 06.08.2020 FR 2008340
(43) Date de publication de la demande: 09.02.2022
(73) Titulaire: VDSYS, 83210 La Farlede (FR)
(72) Inventeur: GESSET, Xavier, 83130 LA GARDE (FR)
(74) Mandataire: Med'inVent Consulting

(56) Documents cités:
- EP-A1- 1 524 890
- EP-A2- 1 137 334
- WO-A1-86/04207
- US-A- 5 398 162
- US-A- 5 800 187
- HYMATOM: "Borne de video protection sur eclairage public", 22 March 2017 (2017-03-22), pages 1 - 4, XP002802476, Retrieved from the Internet <URL:http://www.hymatom.com/wp-content/uploads/2016/12/FP-Borne-de-video-protection-sur-eclairage-public-2016-08_A3.pdf>

## Description

### [Domaine technique

La présente invention concerne d'une manière générale un ensemble électronique modulaire ainsi qu'une borne vidéo nomade comportant un tel ensemble électronique modulaire.

### Technique antérieure

Afin de faciliter leur maintenance, de plus en plus de systèmes électroniques sont dotés de modules électroniques interchangeables montés de manière amovible sur un support.

Il est par exemple bien connu dans le domaine informatique de disposer côte à côte ou de manière superposée les différents modules électroniques dans des racks ou baies.

La face arrière de chaque module comprend généralement au moins un connecteur prévu pour venir se brancher sur un connecteur correspondant ménagé dans le fond du rack lors de la mise en place à coulissement de ce module dans le logement lui étant attribué et de sorte à établir les connexions électriques nécessaires à son fonctionnement.

Ces modules comportent en outre une façade aux dimensions standardisées et prévue pour être fixée par chacune de ses extrémités sur le rack via des moyens de verrouillage tels que des vis.

On retrouve également ce type d'agencement modulaire dans les dispositifs de commande d'automatismes.

Le document EP 0 542 594 A1 décrit ainsi un ensemble électronique modulaire d'un dispositif de commande d'automatismes, comprenant :
- plusieurs modules électroniques comprenant chacun un boîtier logeant au moins un équipement électronique ; et
- un support prévu pour accueillir de manière amovible lesdits modules, ce support comportant un châssis comprenant un panneau vertical ainsi que des moyens de montage à pivotement portés par ce châssis et aptes à coopérer aves des moyens complémentaires prévus sur chacun desdits modules pour permettre leur montage dans une position de service dans laquelle ces modules sont agencés côte à côte suivant une direction prédéterminée parallèle audit panneau et où leurs faces avant s'étendent coplanairement.

Ces moyens de montage à pivotement comportent une paroi horizontale d'appui située à l'extrémité inférieure du support et apte à coopérer avec une face de pose correspondante d'un boîtier, ainsi que des ressorts de serrage à lame fixés au panneau et dont les extrémités inférieures sont logées partiellement dans des ouvertures respectives ménagées dans cette paroi d'appui.

Les modules comportent une butée à profil arrondi saillant vers l'arrière de l'extrémité inférieure de leur boîtier et prévue pour venir s'appliquer frontalement sur le panneau en demeurant en appui contre ce panneau durant toute la phase de pivotement du module.

Chaque module comprend également une portée ménagée dans la partie inférieure du boîtier et prévue pour coopérer avec l'extrémité inférieure d'un ressort correspondant lors du pivotement du module de sorte à générer une mise en contrainte progressive du ressort permettant, lorsque le module vient occuper sa position de service, d'assurer son pré-maintien dans cette position.

La fixation du module sur le support est ensuite réalisée à l'aide d'une vis de fixation traversant son boîtier et venant se visser sur un écrou ménagé sur ce support.

En cas de dysfonctionnement, les modules défaillants peuvent ainsi être retirés du support par un opérateur et remplacés par de nouveaux modules.

Le document EP 1 524 890 décrit un système similaire utilisant une liaison pivotante démontable avec une fixation par vis des modules lorsque ceux-ci sont en position.

Dans le cas de dispositifs installés en hauteur (par exemple, une caméra de vidéosurveillance montée sur un pylône) dont l'accès nécessite le recours à des échelles voire à des nacelles mobiles portées par un bras, les conditions de travail de l'agent assurant la maintenance sont largement dégradées à cause notamment d'une limitation de la liberté de mouvement de l'opérateur mais également du fait qu'une telle nacelle ou échelle est particulièrement sensible aux conditions climatiques (vent, pluie, etc.).

Les opérations de remplacement des modules défaillants s'avèrent ainsi nettement plus délicates à réaliser qu'au sol (notamment celles de dévissage et le revissage des vis de fixation de ces modules sur le support qui réquisitionnent les deux mains de l'opérateur), ce qui allonge leur durée et peut également entraîner des chutes accidentelles de ces modules.

D'autres arrangements de l'art antérieur sont connus des documents EP 1 137 334, US 5 398 162, WO 86/04207 et US 5 800 187. Le document de l'art antérieur hymatom: "Borne de vidéo protection sur éclairage public",, 22 mars 2017 (2017-03-22), pages 1-4, XP002802476, Extrait de l'Internet:URL:http://www.hymatom.com/wp-content/ uploads/2016/12/FP-Borne-de-video-protection-sur-eclairage-public-2016-08_A3.pdf décrit une borne de protection sur éclairage public.

### Résumé de l'invention

La présente invention vise donc à faciliter l'installation et le retrait des modules sur le support.

Elle propose à cet effet un module électronique comprenant un boîtier logeant au moins un équipement électronique, ledit module étant prévu pour être monté de manière amovible dans une position de service sur un support par un mouvement de pivotement autour d'un axe de rotation.

Selon l'invention, le module comporte également un crochet de clippage saillant à l'extérieur de son boîtier et apte à être clipsé de manière amovible sur une tige pivot ménagée sur ledit support et s'étendant suivant ledit axe de rotation, le crochet de clippage étant adapté pour assurer un maintien en position du module autour de la tige pivot tout en permettant un déclipsage par l'opérateur en exerçant une force supplémentaire à l'aide d'une seule main.

Ne nécessitant l'utilisation d'aucun outil particulier, les opérations de retrait d'un tel module défaillant et de mise en place d'un module de remplacement sont ainsi facilitées par rapport à l'art antérieur, notamment lorsque ces opérations doivent s'effectuer dans des conditions de travail difficiles. De plus, le clippage du module permet d'assurer le maintien dudit module en position ouverte, le retrait dudit module nécessitant l'application d'une force supplémentaire par l'opérateur pour le détacher. Ainsi, le risque de chute du module se trouve limité.

Selon un mode de réalisation préféré permettant notamment d'optimiser les coûts de fabrication, le module peut présenter une forme sensiblement parallélépipédique et comporte :
- un corps de boîtier creux doté d'une paroi avant dans laquelle est ménagée une fenêtre ;
- un capot plat constituant l'une des parois latérales dudit boîtier et fixable de manière amovible sur ledit corps de boîtier ; et
- une plaquette rapportable de manière amovible contre la face interne de ladite paroi avant de sorte à recouvrir ladite fenêtre, la plaquette du boîtier d'au moins l'un desdits modules étant pourvue d'ouvertures agencées en regard de ports de branchement agencés sur le ou lesdits équipements électroniques contenus dans ce boîtier.

Afin de faciliter son démontage du support, le module peut comporter avantageusement un organe de préhension saillant à l'extérieur de son boîtier et permettant de faciliter sa manipulation à pivotement.

Cet organe de préhension peut par exemple être constitué par une excroissance s'étendant dans le prolongement de sa face avant

L'invention vise également sous un deuxième aspect, un support prévu pour accueillir de manière amovible au moins un tel module électronique et comportant un châssis comprenant un panneau ainsi que des moyens de montage à pivotement portés par ce châssis et aptes à coopérer avec des moyens complémentaires prévus sur chaque au moins dit module pour permettre son montage par un mouvement de pivotement autour d'un axe de rotation dans une position de service.

Les moyens de montage à pivotement comportent une tige cylindrique pivot s'étendant suivant ledit axe de rotation et apte à recevoir par clipsage un crochet de clippage ménagé sur chaque au moins dit module.

Afin de faciliter le montage de ce support dans un coffret ou contre un mur, ledit panneau du châssis peut être avantageusement pourvu d'orifices aptes à permettre la fixation par vissage dudit support sur une paroi d'accueil.

De manière à optimiser son coût de revient, ledit châssis peut être constitué de préférence par une plaque métallique découpée et pliée.

Le support peut également comporter, outre ledit panneau s'étendant verticalement, un plateau s'étendant horizontalement en retour d'équerre et vers l'avant depuis le bord inférieur du panneau, ainsi que deux joues latérales verticales s'étendant vers le haut en regard l'une de l'autre depuis les portions avant des deux bords latéraux du plateau et entre lesquelles s'étend ladite tige pivot.

Le plateau peut avantageusement être pourvu de moyens permettant d'assurer la fixation d'autres modules électroniques sur chacune de ses deux faces opposées.

L'invention vise également sous un troisième aspect, un ensemble électronique modulaire comportant plusieurs modules électroniques selon l'invention comprenant chacun un boîtier logeant au moins un équipement électronique, ainsi qu'un support selon l'invention prévu pour accueillir de manière amovible lesdits modules.

Le support comporte un châssis comprenant un panneau ainsi que des moyens de montage à pivotement portés par ce châssis et aptes à coopérer avec des moyens complémentaires prévus sur chacun desdits modules pour permettre leur montage dans une position de service dans laquelle ces modules sont agencés côte à côte suivant une direction prédéterminée parallèle audit panneau et où leurs faces avant s'étendent coplanairement.

Le montage s'effectue via un mouvement de pivotement autour d'un axe de rotation parallèle à ladite direction prédéterminée.

Le support peut comporter avantageusement des moyens magnétiques de retenue interagissant avec des moyens complémentaires prévus sur lesdits modules de sorte à générer une force d'attraction magnétique apte à assurer leur maintien dans ladite position de service.

Lesdits moyens magnétiques de retenue peuvent comporter par exemple une barrette ferromagnétique portée par ledit panneau et s'étendant suivant une direction parallèle à ladite direction prédéterminée et audit axe de rotation, cette barrette étant apte à coopérer, pour chaque dit module, avec un aimant permanent respectif fixé à l'intérieur de son boîtier.

Afin d'éviter que les modules ne puissent se décrocher accidentellement du support (par exemple en cas d'application d'un effort de poussée trop important sur ces derniers lorsque des câbles y sont branchés, le support peut comporter des moyens de butée aptes à coopérer avec les boîtiers desdits modules lorsqu'ils occupent leur position de service et de sorte à s'opposer au déclipsage de leurs crochets de ladite tige pivot.

Ces moyens de butée peuvent par exemple consister en une seconde tige portée par ledit panneau et s'étendant suivant une direction parallèle à ladite direction prédéterminée et audit axe de rotation.

L'invention vise également sous un quatrième aspect, un coffret électronique pour borne vidéo nomade prévu pour être raccordé à au moins une caméra de surveillance et hébergeant un tel ensemble électronique modulaire assurant l'alimentation de la au moins dite caméra ainsi que la transmission et le stockage des images.

L'invention vise enfin sous un cinquième aspect, une borne vidéo nomade comportant au moins une caméra ainsi qu'un tel coffret électronique.

### Brève description des dessins

L'exposé de l'invention sera maintenant poursuivi par la description détaillée d'un exemple de réalisation, donnée ci-après à titre illustratif mais non limitatif, en référence aux dessins annexés, sur lesquels :
La figure 1 représente une vue en perspective d'une borne vidéo nomade comportant une caméra et un coffret hébergeant un ensemble électronique modulaire selon l'invention.
La figure 2 est une vue agrandie en perspective de cet ensemble électronique de modulaire constitué d'un support portant plusieurs modules électroniques.
La figure 3 représente une vue en perspective du support de l'ensemble électronique de la figure 2.
La figure 4 est une vue en perspective de l'un des modules de l'ensemble électronique de la figure 2.
La figure 5 représente une vue en coupe de l'ensemble électronique de la figure 2, prise selon un plan longitudinal vertical traversant le module de la figure 4.
La figure 6 illustre une première étape du montage d'un module électronique sur le support.
La figure 7 illustre une deuxième étape du montage d'un module électronique sur le support.
La figure 8 illustre un détail d'un module électronique.

### Description détaillée

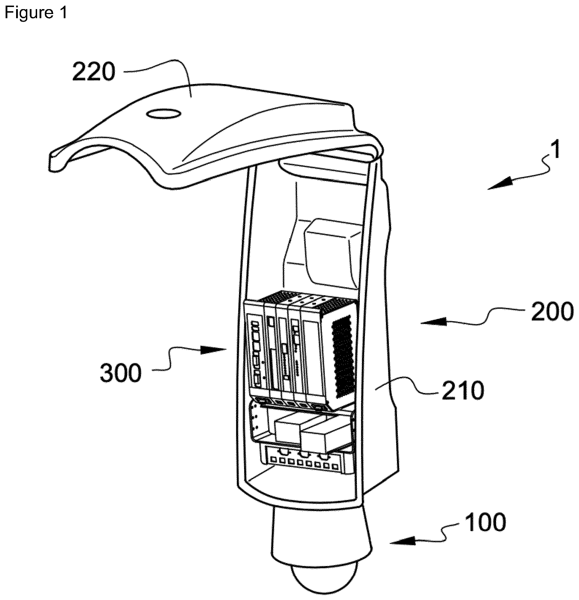

La figure 1 représente une vue en perspective d'une borne vidéo nomade 1 prévue pour être fixée en hauteur sur du mobilier urbain tel que par exemple un mât d'éclairage public.

Cette borne vidéo nomade 1 comporte une caméra 100 ainsi qu'un coffret électronique 200 assurant l'alimentation de la caméra ainsi que la transmission et le stockage des images capturées par cette caméra.

La caméra 100 qui intègre un système de traitement vidéo apte à émettre une alarme codifiée en cas de danger potentiel sur la voie publique, est avantageusement montée sur une tourelle de sorte à permettre son pilotage à distance en zoom et en positionnement par un centre de surveillance urbaine (CSU) vers lequel les images qu'elles capturent sont transmises en temps réel.

Le coffret 200 comprend un corps principal creux 210 globalement parallélépipédique et ouvert sur sa face frontale, ainsi qu'un couvercle de fermeture 220 monté pivotant sur le bord avant supérieur du corps 210 entre une position abaissée de fermeture (non représentée) dans laquelle il recouvre ce corps 210 et une position relevée d'ouverture illustré par la figure 1 dans laquelle il s'étend sensiblement horizontalement en débord de ce corps 210.

Le coffret 200 comprend par ailleurs des moyens permettant de verrouiller le couvercle 220 dans sa position abaissée de fermeture afin de condamner l'accès de manière sécurisée à l'intérieur de ce coffret.

Ces moyens de verrouillage sécurisé sont par exemple constitués par une serrure batteuse, non représentée, comportant un barillet monté sur le couvercle 220, ainsi qu'un pêne monté rotatif à quart de tour sur ce barillet et étant actionnable par l'intermédiaire d'une clé introduite de manière amovible dans ce dernier.

Afin d'assister l'ouverture du couvercle 220 et d'assurer son maintien en position ouverte le, le coffret 200 peut comporter également de manière avantageuse au moins un vérin d'assistance non représenté dont les deux extrémités sont couplées, par un axe ou une rotule d'articulation, respectivement au couvercle 220 et au corps 210.

Le coffret 200 héberge en outre une pluralité d'équipements électroniques formant un circuit d'alimentation, de transmission et de stockage des images,

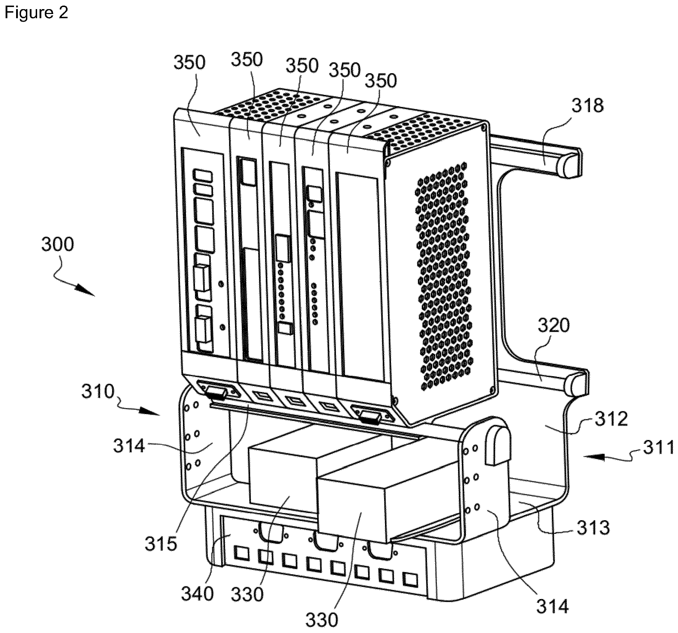

Tous les équipements électroniques logés dans le coffret 200 sont agencés sur un ensemble électronique modulaire 300 selon l'invention, représenté seul sur la figure 2.

Cet ensemble électronique modulaire 300 comporte un support 310 fixé contre la paroi de fond du corps 210 du coffret 200 et portant une pluralité de modules 330, 340, 350 hébergeant les divers équipements électroniques.

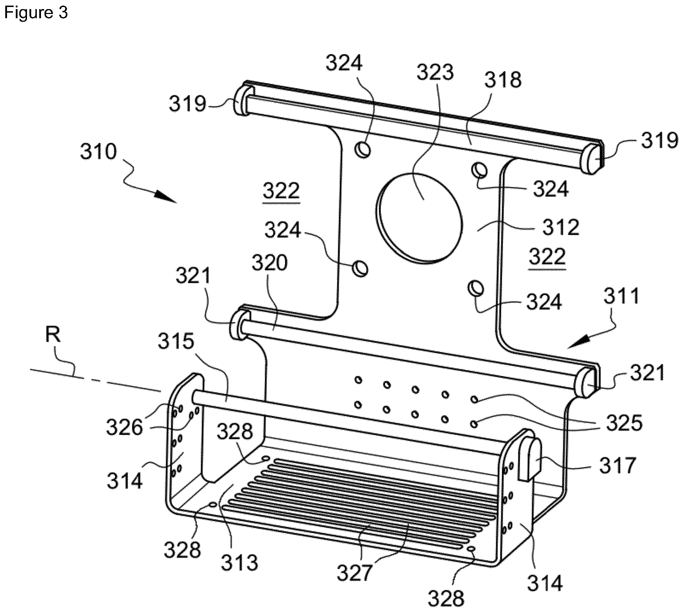

Le support 310, représenté seul sur la figure 3, comporte un châssis 311, constitué avantageusement par une plaque métallique découpée et pliée, comprenant :
- un panneau vertical 312 ;
- un plateau horizontal 313 s'étendant en retour d'équerre et vers l'avant depuis le bord inférieur du panneau 312 ; et
- deux joues latérales verticales planes 314 s'étendant vers le haut en regard l'une de l'autre depuis les portions avant des deux bords latéraux du plateau 313.

Le support 310 comporte également une première tige cylindrique métallique pivot 315 s'étendant selon une direction transversale entre les deux joues latérales 314 suivant un axe horizontal de rotation R parallèle au panneau 312, et dont les deux extrémités traversent des orifices circulaires correspondants ménagés dans ces joues 314.

Le verrouillage en translation de cette tige 315 est assuré grâce à deux butées plastiques 317 fixées par vissage sur les faces externes des joues 314 et recouvrant ces orifices.

Le support 310 comporte en outre une barrette ferromagnétique de retenue 318 s'étendant selon une direction transversale en regard et au devant de la partie supérieure du panneau 312, les deux extrémités de cette barrette 318 étant supportées par deux flasques latéraux plastiques 319 saillants vers l'avant depuis les deux extrémités latérales du panneau 312 auquel ils sont fixés par vissage.

Le support 310 comporte enfin une butée constituée par exemple par une seconde tige cylindrique métallique 320 s'étendant selon une direction transversale en regard et au devant de la partie inférieure du panneau 312, au dessus du niveau de la première tige pivot 315, les deux extrémités de cette seconde tige 320 étant portées par deux flasques latéraux plastiques 321 saillants vers l'avant depuis les deux extrémités latérales du panneau 312 auquel ils sont fixés par vissage.

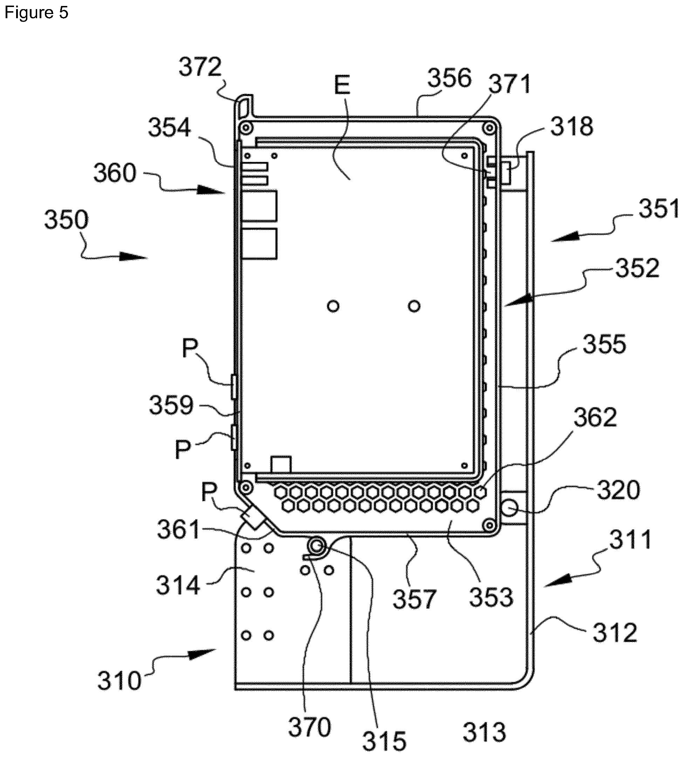

On remarquera à l'appui de la figure 5 que la ligne horizontale formant l'extrémité avant cette seconde tige 320 et la face avant de la barrette 318 s'étendent dans un même plan vertical situé en avant du panneau 312.

Les butées 317 et flasques plastiques 319, 321 sont avantageusement obtenues par un procédé d'impression tridimensionnel à partir d'une pluralité de couches superposées d'un polymère thermoplastique tel que l'ABS (Acrylonitrile Butadiene Styrene) ou le PLA (Polylactic Acid).

Selon des variantes de réalisation non représentées, la fixation des extrémités de la tige 315 aux joues 314 peut être réalisée par un cordon ou des points de soudure. Les extrémités de la barrette ferromagnétique 318 et celles de la seconde tige 320 peuvent également être fixées par soudage à des pattes métalliques réalisées dans la plaque métallique formant le châssis 311.

La partie centrale du panneau 312, s'étendant entre la barrette ferromagnétique 318 et la seconde tige 320, présente deux échancrures latérales 322 et une découpe 323 permettant de réduire la masse du support 310. Cette portion centrale présente également quatre orifices 324 prévus pour assurer la fixation par vissage de ce support 310 contre la paroi de fond du corps 210 du coffret 200.

La partie inférieure du panneau 312 présente, en dessous de la seconde tige 320, au moins une série d'orifices 325 alignés horizontalement et aptes à permettre d'assurer la fixation d'au moins un rail standardisé de type DIN (non représenté) pour le montage de modules électriques ou électroniques additionnels.

Les joues latérales verticales planes 314 présentent également de manière avantageuse des orifices 326 prévus pour y permettre la fixation par encliquetage d'agrafes de bridage, non représentées, permettant de guider le cheminement de câbles Ethernet et d'alimentation.

Le plateau horizontal 313 présente une série de fentes parallèles 327 s'étendant sur la majeure partie de sa surface et permettant d'y fixer par vissage au moins un module électronique 330 reposant contre la face supérieure de ce plateau 313.

Ce plateau 313 présente également, à proximité de ses quatre coins, quatre orifices de fixation 328 permettant d'y fixer par vissage au moins un module électronique 340 reposant contre la face inférieure de ce plateau 313.

Présentent des dimensions identiques en hauteur et en profondeur, les modules 350 qui sont quant à eux montés articulés à pivotement sur la première tige pivot 315 du support 310.

La figure 2 montre ces modules 350 dans leur position de service dans laquelle ils sont agencés côte à côte suivant une direction transversale parallèle au panneau 312, avec leurs faces avant s'étendant coplanairement.

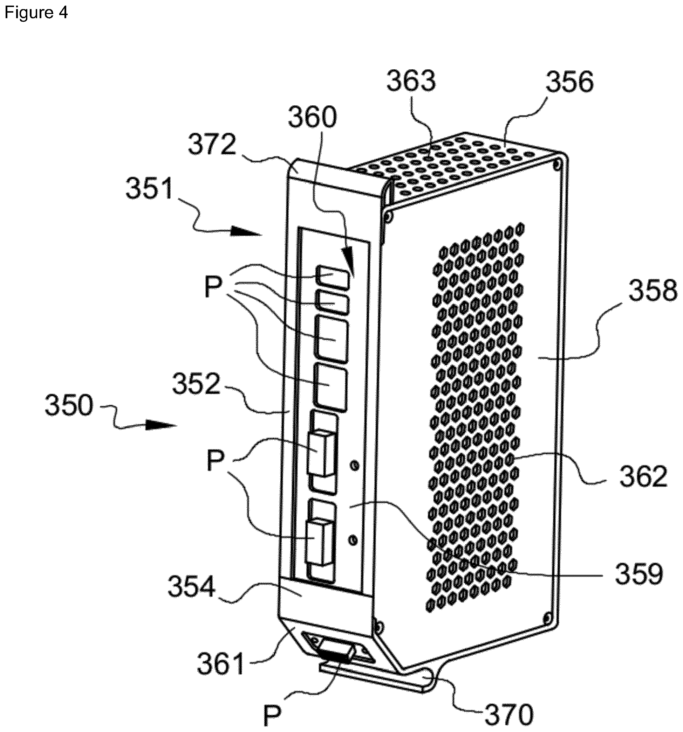

En référence aux figures 4 et 5, chacun de ces modules 350 comporte un boîtier 351 de forme sensiblement parallélépipédique hébergeant au moins un équipement électronique E doté de ports P permettant de le connecter par via des câbles non représentés aux équipements électroniques des autres modules.

Ce boîtier 351 est constitué :
- d'un corps de boîtier creux 352 comprenant une première paroi latérale 353 ainsi que des parois avant 354, arrière 355, supérieure 356 et inférieure 357 ;
- d'un capot plat 358 formant la seconde paroi latérale de ce boîtier et fixé de manière amovible sur ce corps de boîtier 352 par une pluralité de vis ; et
- d'une plaquette rectangulaire 359 rapportable de manière amovible contre la face interne de la paroi avant 354 du corps de boîtier 332 (ses bords périphériques venant se loger dans une gorge non visible ménagée sur la face interne de la paroi avant 354) et recouvrant une fenêtre rectangulaire 360 de dimensions légèrement inférieures ménagée sur la majeure partie de la surface de cette paroi avant 354, cette plaquette 359 pouvant présenter une pluralité d'ouvertures agencées en regard de certains ports P de sorte à permettre le branchement de câbles sur ces ports depuis l'extérieur du module 350.

En variante, cette plaquette 359 peut être portée par une carte électronique logée dans le boîtier 351.

Une telle constitution des boîtiers 351 permet ainsi d'utiliser une unique référence de capot 358 pour l'ensemble des modules 330 même si ces derniers peuvent présenter des largeurs différentes. La présence des plaquettes 359 permet également de personnaliser la face avant de ces boîtiers 351 tout en utilisant un nombre réduit de références de corps de boîtier 352 (par exemple, une première référence de largeur « standard » et une seconde référence de plus grande largeur pour des modules accueillant des équipements plus volumineux),

Les corps de boîtier 352 et les capots 358 sont avantageusement obtenues par un procédé d'impression tridimensionnel à partir d'une pluralité de couches superposées d'un polymère thermoplastique tel que l'ABS (Acrylonitrile Butadiene Styrene) ou le PLA (Polylactic Acid), tandis que les plaquettes 359 sont de préférence venues de moulage à partir d'un matériau thermoplastique.

Le coin inférieur avant de chaque boîtier 351 présente en outre avantageusement un profil biseauté définissant une paroi oblique 361 pourvue d'une ouverture d'accueil pour un port de connexion P.

Le capot 358 et la paroi latérale 353 du corps de boîtier 332 sont de préférence pourvus de trous d'aération hexagonaux 362 agencés en nid d'abeille de sorte à permettre l'aération de l'intérieur des modules électroniques 350.

D'autres trous d'aération 363 et/ou de passage pour antennes peuvent également être ménagés sur la paroi supérieure 366 des boîtiers 351.

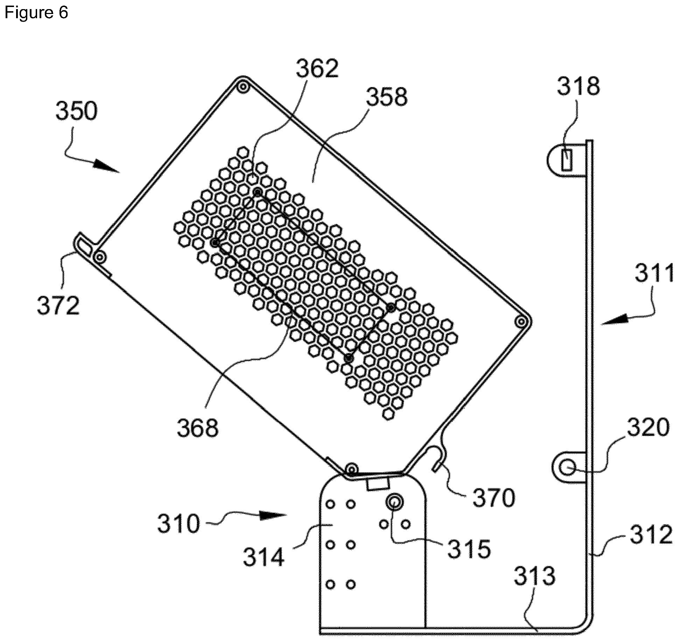

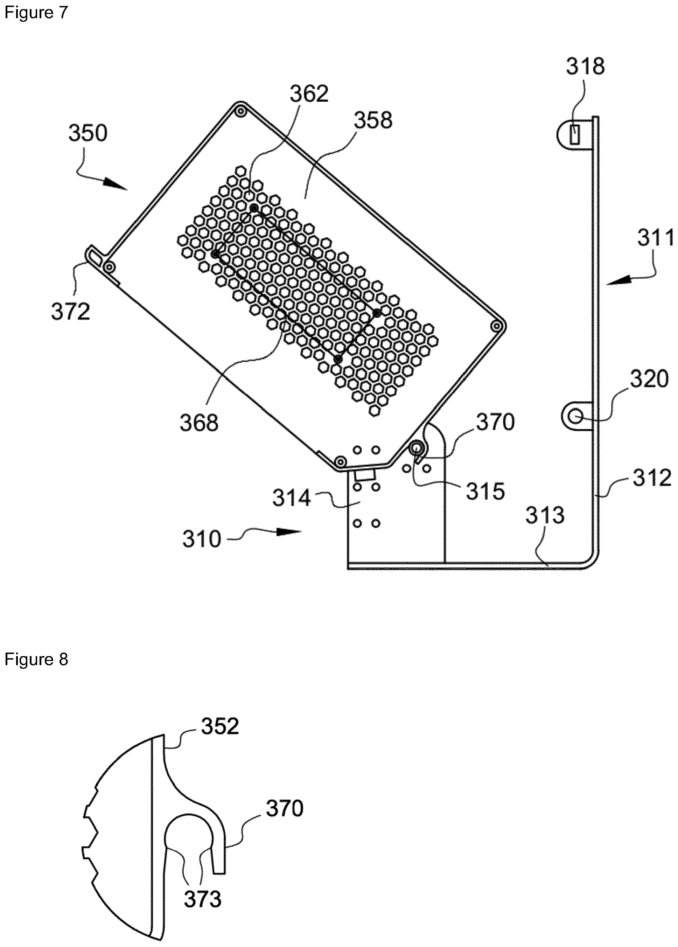

La face interne du capot 358 est en outre avantageusement dotée de moyens d'accueil et de fixation 368 (voir figures 6 et 7) pour un ventilateur (non représenté) permettant de générer un flux d'air forcé améliorant le refroidissement de l'intérieur des modules électroniques.

Chaque module 350 comporte également un crochet de clippage 370 saillant de la paroi inférieure 357 de son boîtier 351 et apte à permettre le montage à pivotement et de manière amovible de ce module sur la première tige cylindrique 315 du support 310 autour de l'axe R de cette tige.

Avantageusement venu de matière d'une seule pièce avec le corps de boîtier 352, ce crochet de clippage 370 présente un profil en forme de U ouvert vers l'avant et dont les faces internes des deux branches présentent chacune un bossage 373 comme illustré sur la figure 8.

En variante, le profil de ce crochet peut être différent et se présenter par exemple sous la forme d'un C ouvert vers l'avant. L'important étant que le crochet de clippage puisse assurer un maintien en position du module autour de la tige tout en permettant un déclipsage par l'opérateur en exerçant une force supplémentaire à l'aide d'une seule main.

Tel qu'illustré sur la figure 5, chacun des modules 350 comporte en outre un aimant permanent 371, fixé contre la face interne de la partie supérieure de la paroi arrière 355 de son boîtier 351, et prévu pour interagir avec la barrette ferromagnétique 318 du support 310 pour assurer la retenue de ce module dans sa position de service.

En variante, les moyens magnétiques de retenue peuvent différer : le support 310 comportant par exemple une barrette aimantée apte à coopérer avec des éléments ferromagnétiques respectifs fixés à l'intérieur des boîtiers 351 des modules 350.

Chaque module 350 comporte enfin un organe de préhension constitué par une excroissance 372 saillant au dessus du boîtier 351 dans le prolongement de sa face avant et avantageusement venu de matière d'une seule pièce avec le corps de boîtier 352.

La présence de cette excroissance 372 permet de faciliter la manipulation à pivotement du module 350 vers l'avant depuis sa position de service et vers une position inclinée autorisant son démontage du support 310 par déclipsage du crochet 370 de ladite tige pivot 315.

Les opérations de mise en place et de retrait d'un module 350 sur le support 310 vont maintenant être décrites en détails à l'appui des figures 6 et 7, sachant que ces opérations sont identiques pour l'ensemble de ces modules 350.

Le boîtier 351 du module 350 à installer doit être présenté au support 310 avec son extrémité supérieure inclinée vers l'avant par rapport à son extrémité inférieure et de sorte que le crochet 370 soit situé légèrement au dessus de la première tige pivot 315 avec son ouverture orientée en regard de cette même tige (voir figure 6).

On notera que l'inclinaison du boîtier 351 est nécessaire afin d'éviter que la seconde tige formant butée 320 n'interagisse avec la face arrière de ce boîtier et empêche le bon positionnement du crochet 270.

Une fois le crochet 270 correctement positionné, celui-ci doit ensuite être clipsé sur la première tige pivot 315 par une simple traction du boîtier 351 vers le bas et tel qu'illustré par la figure 7.

L'opérateur n'a alors plus qu'à faire pivoter le module 350 vers l'arrière (c'est-à-dire dans le sens horaire en référence à la figure 7) jusqu'à sa position de service illustrée par la figure 5 et dans laquelle sa face arrière vient simultanément en butée contre la barrette ferromagnétique 318 et la seconde tige 320.

Des câbles de liaison peuvent dès lors être branchés sur les ports présents sur la face avant de ce module 350 afin de le connecter aux autres modules.

Ce module 350 est par ailleurs retenu dans cette position de service grâce à la force magnétique exercée par la barrette ferromagnétique 318 sur l'aimant permanent 371 fixé à hauteur de cette barrette 318 contre la face interne de la paroi arrière 355 du boîtier 351.

On remarquera que la seconde tige formant butée 320 permet de s'opposer à tout déclipsage accidentel du crochet 370 (entraînant la désolidarisation du module 350 du support 310) en cas d'application d'un effort de poussée trop important sur la face avant de ce module 350 lors du branchement des câbles.

Pour démonter le module 350, l'opérateur doit tout d'abord le faire pivoter vers l'avant à l'encontre de la force magnétique exercée par la barrette 318 en s'aidant de l'organe de préhension 372 et jusqu'à ce qu'il atteigne une position inclinée permettant une meilleure préhension de ce module et autorisant son démontage du support 310 par déclipsage de son crochet 270 de la tige pivot 315.

Selon des variantes de réalisation non représentées de l'ensemble électronique selon l'invention le support peut être conformé différemment.

Les tiges 320 ainsi que la barrette 318 peuvent ainsi par exemple être portées par un panneau s'étendant horizontalement de sorte que les modules 350 reposent par leur face inférieure sur ces dernières lorsqu'ils occupent leur position de service.

Les modules électroniques peuvent également être conformés autrement et leur nombre, leur forme et/ou leur agencement peut différer.

Les modules 350 peuvent notamment comporter chacun un connecteur électrique saillant d'une fenêtre ménagée dans leur boîtier et apte à venir se brancher sur des connecteurs complémentaires saillant du panneau du support lors de leur montage à pivotement sur ce support.

On précisera enfin que l'usage de l'ensemble électronique selon l'invention ne saurait être limitée au domaine des systèmes vidéo nomades mais qu'il peut être intégré dans d'autres types de dispositifs assurant des fonctions différentes, et en particulier dans un système de commande d'automatismes.

## Revendications

1. Module électronique (350) comprenant un boîtier (351) logeant au moins un équipement électronique (E), ledit module étant prévu pour être monté de manière amovible dans une position de service sur un support par un mouvement de pivotement autour d'un axe de rotation (R) ; **caractérisé en ce qu'**il comporte un crochet de clippage (370) saillant à l'extérieur de son boîtier (351) et apte à être clipsé de manière amovible sur une tige pivot ménagée sur ledit support et s'étendant suivant ledit axe de rotation (R), le crochet de clippage (370) étant adapté pour assurer un maintien en position du module autour de la tige pivot tout en permettant un déclipsage par l'opérateur en exerçant une force supplémentaire à l'aide d'une seule main.

2. Module électronique (350) selon la revendication 1, dans lequel ledit boîtier (351) présente une forme sensiblement parallélépipédique et comporte :
- un corps de boîtier creux (352) doté d'une paroi avant (354) dans laquelle est ménagée une fenêtre (360) ;
- un capot plat (358) constituant l'une des parois latérales dudit boîtier (351) et fixable de manière amovible sur ledit corps de boîtier (352) ; et
- une plaquette (359) rapportable de manière amovible contre la face interne de ladite paroi avant (354) de sorte à recouvrir ladite fenêtre (360), la plaquette (359) du boîtier (351) d'au moins l'un desdits modules (350) étant pourvue d'ouvertures agencées en regard de ports de branchement (P) agencés sur le ou lesdits équipements électroniques (E) contenus dans ce boîtier (351).

3. Module électronique (350) selon l'une des revendications 1 ou 2, dans lequel ce dernier comporte un organe de préhension (372) saillant à l'extérieur de son boîtier (351) et permettant de faciliter sa manipulation à pivotement.

4. Module électronique (350) selon la revendication 3, dans lequel ledit organe de préhension est constitué par une excroissance (372) s'étendant dans le prolongement de sa face avant.

5. Support (310) prévu pour accueillir de manière amovible au moins un module électronique selon l'une des revendication 1 à 4 et comportant un châssis (311) comprenant un panneau (312) ainsi que des moyens de montage à pivotement (315) portés par ce châssis (311) et aptes à coopérer avec des moyens complémentaires (370) prévus sur chaque au moins dit module (350) pour permettre son montage par un mouvement de pivotement autour d'un axe de rotation (R) dans une position de service, **caractérisé en ce que** lesdits moyens de montage à pivotement comportent une tige cylindrique pivot (315) s'étendant suivant ledit axe de rotation (R) et apte à recevoir par clipsage un crochet de clippage (370) ménagé sur chaque au moins dit module (350).

6. Support (310) selon la revendication 5, dans lequel ledit panneau (312) du châssis (311) est pourvu d'orifices (324) aptes à permettre la fixation par vissage dudit support (310) sur une paroi d'accueil.

7. Support (310) selon l'une des revendications 5 ou 6, dans lequel ledit châssis (311) est constitué par une plaque métallique découpée et pliée.

8. Support (310) selon l'une des revendications 5 à 7, dans lequel ledit châssis (311) comprend, outre ledit panneau s'étendant verticalement (312), un plateau (313) s'étendant horizontalement en retour d'équerre et vers l'avant depuis le bord inférieur du panneau (312), ainsi que deux joues latérales verticales (314) s'étendant vers le haut en regard l'une de l'autre depuis les portions avant des deux bords latéraux du plateau (313) et entre lesquelles s'étend ladite tige pivot (315).

9. Support (310) selon la revendication 8, dans lequel ledit plateau (313) est pourvu de moyens (327, 328) permettant d'assurer la fixation d'autres modules électroniques (330, 340) sur chacune de ses deux faces opposées.

10. Ensemble électronique modulaire (300) comportant :
- plusieurs modules électroniques (350) comprenant chacun un boîtier (351) logeant au moins un équipement électronique (E) ; et
- un support (310) prévu pour accueillir de manière amovible lesdits modules (350), ce support (310) comportant un châssis (311) comprenant un panneau (312) ainsi que des moyens de montage à pivotement (315) portés par ce châssis (311) et aptes à coopérer avec des moyens complémentaires (370) prévus sur chacun desdits modules (350) pour permettre leur montage dans une position de service dans laquelle ces modules (350) sont agencés côte à côte suivant une direction prédéterminée parallèle audit panneau (312) et où leurs faces avant s'étendent coplanairement, ledit montage s'effectuant via un mouvement de pivotement autour d'un axe de rotation (R) parallèle à ladite direction prédéterminée ;
**caractérisé en ce que** lesdits modules sont conformes à l'une des revendications 1 à 4 et **en ce que** ledit support est conforme à l'une des revendications 5 à 9.

11. Ensemble électronique modulaire (300) selon la revendication 10, dans lequel ledit support (310) comporte des moyens magnétiques de retenue (318) interagissant avec des moyens complémentaires (371) prévus sur lesdits modules (350) de sorte à générer une force d'attraction magnétique apte à assurer leur maintien dans ladite position de service.

12. Ensemble électronique modulaire (300) selon la revendication 11, dans lequel lesdits moyens magnétiques de retenue comportent une barrette ferromagnétique (318) portée par ledit panneau (312) et s'étendant suivant une direction parallèle à ladite direction prédéterminée et audit axe de rotation (R), cette barrette (318) étant apte à coopérer, pour chaque dit module (350), avec un aimant permanent respectif (371) fixé à l'intérieur de son boîtier (351).

13. Ensemble électronique modulaire (300) selon l'une des revendications 10 à 12, dans lequel ledit support (310) comporte des moyens de butée (320) aptes à coopérer avec les boîtiers (351) desdits modules (350) lorsqu'ils occupent leur position de service et de sorte à s'opposer au déclipsage de leurs crochets (370) de ladite tige pivot (315).

14. Ensemble électronique modulaire (300) selon la revendication 13, dans lequel lesdits moyens de butée consistent en une seconde tige (320) portée par ledit panneau (312) et s'étendant suivant une direction parallèle à ladite direction prédéterminée et audit axe de rotation (R).

15. Coffret électronique (200) pour borne vidéo nomade (1) prévu pour être raccordé à au moins une caméra de surveillance (100) et hébergeant un ensemble électronique modulaire (300) assurant l'alimentation de la au moins dite caméra (100) ainsi que la transmission et le stockage des images ; **caractérisé en ce que** ledit ensemble électronique modulaire (300) est conforme à l'une des revendications 10 à 14.

16. Borne vidéo nomade (1) comportant au moins une caméra (100) ainsi qu'un coffret électronique (200) selon la revendication 15.

## Patentansprüche

1. Elektronikmodul (350), das ein Gehäuse (351) umfasst, das mindestens ein Elektronikgerät (E) aufnimmt, wobei das genannte Modul zum lösbaren Montieren in einer Betriebsposition auf einem Träger durch eine Schwenkbewegung um eine Drehachse (R) vorgesehen ist;
**dadurch gekennzeichnet, dass** es einen Einrasthaken (370) aufweist, der aus seinem Gehäuse (351) herausragt und zum lösbaren Einrasten auf einen auf dem genannten Träger ausgebildeten und sich entlang der genannten Drehachse (R) erstreckenden Drehstift fähig ist, wobei der Einrasthaken (370) so ausgelegt ist, dass er das Inpositionhalten des Moduls um den Drehstift gewährleistet und dabei das Ausrasten durch den Bediener unter Ausübung einer zusätzlichen Kraft mit nur einer Hand zulässt.

2. Elektronikmodul (350) nach Anspruch 1, wobei das genannte Gehäuse (351) eine im Wesentlichen parallelepipedische Form aufweist und Folgendes umfasst:
- einen hohlen Gehäusekörper (352) mit einer Vorderwand (354), in der ein Fenster (360) ausgebildet ist;
- eine flache Abdeckung (358), die eine der Seitenwände des genannten Gehäuses (351) bildet und lösbar an dem genannten Gehäusekörper (352) befestigt werden kann; und
- eine kleine Platte (359), die lösbar an der Innenseite der genannten Vorderwand (354) angebracht werden kann, so dass sie das genannte Fenster (360) abdeckt, wobei die kleine Platte (359) des Gehäuses (351) mindestens eines der genannten Module (350) mit Öffnungen versehen ist, die gegenüber Anschlussports (P) angeordnet sind, die an dem oder den genannten in diesem Gehäuse (351) enthaltenen elektronischen Gerät(en) (E) angeordnet sind.

3. Elektronikmodul (350) nach Anspruch 1 oder 2, wobei Letzteres ein Greiforgan (372) umfasst, das aus seinem Gehäuse (351) herausragt und seine Schwenkbedienung erleichtern kann.

4. Elektronikmodul (350) nach Anspruch 3, wobei das genannte Greiforgan aus einem Ansatz (372) besteht, der sich in der Verlängerung seiner Vorderseite erstreckt.

5. Träger (310), der zum lösbaren Aufnehmen mindestens eines Elektronikmoduls nach einem der Ansprüche 1 bis 4 vorgesehen ist und der einen Rahmen (311) mit einem Panel (312) sowie Mittel zur schwenkbaren Montage (315) umfasst, die von diesem Rahmen (311) getragen werden und mit komplementären Mitteln (370) zusammenwirken können, die an jedem mindestens einen genannten Modul (350) vorgesehen sind, um dessen Montage durch eine Schwenkbewegung um eine Drehachse (R) in einer Betriebsposition zuzulassen, **dadurch gekennzeichnet, dass** die genannten Mittel zur schwenkbaren Montage einen zylindrischen Drehstift (315) umfassen, der sich entlang der genannten Drehachse (R) erstreckt und einen an jedem mindestens einen genannten Modul (350) ausgebildeten Einrasthaken (370) durch Einrasten aufnehmen kann.

6. Träger (310) nach Anspruch 5, wobei das genannte Panel (312) des Rahmens (311) mit Löchern (324) versehen ist, die das Schraubbefestigen des genannten Trägers (310) an einer Aufnahmewand zulassen können.

7. Träger (310) nach Anspruch 5 oder 6, wobei der genannte Rahmen (311) aus einer gestanzten und gebogenen Metallplatte besteht.

8. Träger (310) nach einem der Ansprüche 5 bis 7, wobei der genannte Rahmen (311) neben dem genannten sich vertikal erstreckenden Panel (312) eine Platte (313), die sich horizontal rechtwinklig und von der Unterkante des Panels (312) nach vorne erstreckt, sowie zwei vertikale Seitenwangen (314) umfasst, die sich von den vorderen Abschnitten der beiden Seitenkanten der Platte (313) einander gegenüberliegend nach oben erstrecken und zwischen denen sich der genannte Drehstift (315) erstreckt.

9. Träger (310) nach Anspruch 8, wobei die genannte Platte (313) mit Mitteln (327, 328) versehen ist, die das Gewährleisten der Befestigung weiterer Elektronikmodule (330, 340) an jeder ihrer beiden gegenüberliegenden Seiten zulassen.

10. Modulare Elektronikbaugruppe (300), die Folgendes umfasst:
- mehrere Elektronikmodule (350), die jeweils ein Gehäuse (351) umfassen, das mindestens ein Elektronikgerät (E) aufnimmt; und
- einen Träger (310), der zum lösbaren Aufnehmen der genannten Module (350) vorgesehen ist, wobei dieser Träger (310) einen Rahmen (311) mit einem Panel (312) sowie Mitteln zur schwenkbaren Montage (315) umfasst, die von diesem Rahmen (311) getragen werden und mit komplementären Mitteln (370) zusammenwirken können, die an jedem der genannten Module (350) vorgesehen sind, um ihre Montage in einer Betriebsposition zuzulassen, in der diese Module (350) Seite an Seite entlang einer vorbestimmten Richtung parallel zu dem genannten Panel (312) angeordnet sind und in der sich ihre Vorderseiten koplanar erstrecken, wobei die genannte Montage über eine Schwenkbewegung um eine Drehachse (R) parallel zu der genannten vorbestimmten Richtung erfolgt;
**dadurch gekennzeichnet, dass** die genannten Module einem der Ansprüche 1 bis 4 entsprechen, und dadurch, dass der genannte Träger einem der Ansprüche 5 bis 9 entspricht.

11. Modulare Elektronikbaugruppe (300) nach Anspruch 10, wobei der genannte Träger (310) magnetische Haltemittel (318) aufweist, die mit komplementären Mitteln (371) zusammenwirken, die an den genannten Modulen (350) vorgesehen sind, um eine magnetische Anziehungskraft zu erzeugen, die ihr Halten in der genannten Betriebsposition gewährleisten kann.

12. Modulare Elektronikbaugruppe (300) nach Anspruch 11, wobei die genannten magnetischen Haltemittel eine ferromagnetische Leiste (318) umfassen, die von dem genannten Panel (312) getragen wird und sich entlang einer Richtung parallel zu der genannten vorbestimmten Richtung und zu der genannten Drehachse (R) erstreckt, wobei diese Leiste (318) für jedes genannte Modul (350) mit einem jeweiligen Permanentmagneten (371) zusammenwirken kann, der im Inneren seines Gehäuses (351) befestigt ist.

13. Modulare Elektronikbaugruppe (300) nach einem der Ansprüche 10 bis 12, wobei der genannte Träger (310) Anschlagmittel (320) aufweist, die mit den Gehäusen (351) der genannten Module (350) zusammenwirken können, wenn diese ihre Betriebsposition einnehmen, und zwar so, dass sie sich dem Ausrasten ihrer Haken (370) aus dem genannten Drehstift (315) widersetzen können.

14. Modulare Elektronikbaugruppe (300) nach Anspruch 13, wobei die genannten Anschlagmittel aus einem zweiten Stift (320) bestehen, der von dem genannten Panel (312) getragen wird und sich entlang einer Richtung parallel zu der genannten vorbestimmten Richtung und zu der genannten Drehachse (R) erstreckt.

15. Elektronikkasten (200) für ein mobiles Videoterminal (1), der zum Anschließen an mindestens eine Überwachungskamera (100) vorgesehen ist und eine modulare Elektronikbaugruppe (300) beherbergt, die die Stromversorgung der mindestens einen genannten Kamera (100) sowie die Übertragung und Speicherung der Bilder gewährleistet; **dadurch gekennzeichnet, dass** die genannte modulare Elektronikbaugruppe (300) einem der Ansprüche 10 bis 14 entspricht.

16. Mobiles Videoterminal (1), das mindestens eine Kamera (100) sowie einen Elektronikkasten (200) nach Anspruch 15 umfasst.

## Claims

1. Electronic module (350) comprising a casing (351) housing at least one item of electronic equipment (E), said module being provided to be removably mounted in an operating position on a support by a pivoting movement about an axis of rotation (R); **characterized in that** it includes a clip hook (370) projecting outside its casing (351) and able to be removably clipped on a pivot rod formed on said support and extending along said axis of rotation (R), the clip hook (370) being adapted to ensure that the module is held in position around the pivot rod while allowing unclipping by the operator by exerting an additional force using only one hand.

2. Electronic module (350) according to claim 1, in which said casing (351) has a substantially parallelepipedal shape and includes:
- a hollow casing body (352) equipped with a front wall (354) in which a window (360) is formed;
- a flat cover (358) constituting one of the side walls of said casing (351) and which can be removably fastened on said casing body (352); and
- a small plate (359) that can be removably fitted against the inner face of said front wall (354) so as to cover said window (360), the small plate (359) of the casing (351) of at least one of said modules (350) being provided with openings arranged opposite connection ports (P) arranged on said item or items of electronic equipment (E) contained in this casing (351).

3. Electronic module (350) according to one of claims 1 or 2, in which the latter includes a gripping member (372) projecting outside its casing (351) and making it possible to facilitate the pivot handling thereof.

4. Electronic module (350) according to claim 3, in which said gripping member is constituted by a projection (372) extending in the extension of its front face.

5. Support (310) provided to removably accommodate at least one electronic module according to one of claims 1 to 4 and including a frame (311) comprising a panel (312) as well as means for pivotable mounting (315) borne by this frame (311) and able to cooperate with complementary means (370) provided on each at least one said module (350) to allow it to be mounted by a pivoting movement about an axis of rotation (R) in an operating position, **characterized in that** said means for pivotable mounting include a cylindrical pivot rod (315) extending along said axis of rotation (R) and able to receive by clipping a clip hook (370) formed on each at least one said module (350).

6. Support (310) according to claim 5, in which said panel (312) of the frame (311) is provided with orifices (324) able to allow the screw fastening of said support (310) on an accommodating wall.

7. Support (310) according to one of claims 5 or 6, in which said frame (311) is constituted by a metal plate that has been cut and folded.

8. Support (310) according to one of claims 5 to 7, in which said frame (311) comprises, in addition to said panel extending vertically (312), a plate (313) extending horizontally at right angles and forwards from the lower edge of the panel (312), as well as two vertical side cheeks (314) extending upwards facing one another from the front portions of the two side edges of the plate (313) and between which said pivot rod (315) extends.

9. Support (310) according to claim 8, in which said plate (313) is provided with means (327, 328) making it possible to ensure the fastening of other electronic modules (330, 340) on each of its two opposite faces.

10. Modular electronic assembly (300) including:
- several electronic modules (350) each comprising a casing (351) housing at least one item of electronic equipment (E); and
- a support (310) provided to removably accommodate said modules (350), this support (310) including a frame (311) comprising a panel (312) as well as means for pivotable mounting (315) borne by this frame (311) and able to cooperate with complementary means (370) provided on each of said modules (350) to allow them to be mounted in an operating position in which these modules (350) are arranged side by side along a predetermined direction parallel to said panel (312) and where their front faces extend in a coplanar manner, said mounting being carried out via a pivoting movement about an axis of rotation (R) parallel to said predetermined direction;
**characterized in that** said modules are according to one of claims 1 to 4 and **in that** said support is according to one of claims 5 to 9.

11. Modular electronic assembly (300) according to claim 10, in which said support (310) includes magnetic retention means (318) interacting with complementary means (371) provided on said modules (350) so as to generate a magnetic attraction force able to ensure that they are held in said operating position.

12. Modular electronic assembly (300) according to claim 11, in which said magnetic retention means include a ferromagnetic bar (318) borne by said panel (312) and extending along a direction parallel to said predetermined direction and to said axis of rotation (R), this bar (318) being able to cooperate, for each said module (350), with a respective permanent magnet (371) fastened to the inside of its casing (351).

13. Modular electronic assembly (300) according to one of claims 10 to 12, in which said support (310) includes stop means (320) able to cooperate with the casings (351) of said modules (350) when they occupy their operating position and so as to oppose the unclipping of their hooks (370) from said pivot rod (315).

14. Modular electronic assembly (300) according to claim 13, in which said stop means consist of a second rod (320) borne by said panel (312) and extending along a direction parallel to said predetermined direction and to said axis of rotation (R).

15. Electronic box (200) for a mobile video terminal (1) provided to be connected to at least one surveillance camera (100) and housing a modular electronic assembly (300) ensuring the powering of the at least one said camera (100) as well as the transmission and storage of images; **characterized in that** said modular electronic assembly (300) is according to one of claims 10 to 14.

16. Mobile video terminal (1) including at least one camera (100) as well as an electronic box (200) according to claim 15.
